# EUROPEAN PATENT APPLICATION

(11) **EP 4 379 788 A1**
(43) Date of publication of application: **05.06.2024**
(21) Application number: 23212674.8
(22) Date of filing: 28.11.2023
(51) Int. Cl.: H01L 23/00, H01L 23/495

(54) **A METHOD OF MANUFACTURING SEMICONDUCTOR DEVICES AND CORRESPONDING SEMICONDUCTOR DEVICE**

(30) Priority: 30.11.2022 IT 202200024687
(71) Applicant: STMicroelectronics International N.V., 1228 Plan-les-Ouates, Geneva (CH)
(72) Inventor: MAZZOLA, Mauro, I-24040 Calvenzano (Bergamo) (IT)
(74) Representative: Bosotti, Luciano

(57) **Abstract**

A semiconductor die (14) is arranged at a die mounting location (12A) of an electrically conductive substrate (12). The electrically conductive substrate (12) comprises an array of electrically conductive leads (12B) having openings (282) at the periphery of the electrically conductive substrate (12).

An electrically conductive clip (28) is arranged in a bridge-like position between the semiconductor die (14) and an electrically conductive lead (12B) in the array of electrically conductive leads (12B) to provide electrical coupling therebetween.

The electrically conductive clip (28) has an end (200, 202) configured to be coupled to the electrically conductive lead (12B).

The end (200, 202) of the electrically conductive clip (28) comprises:
a planar proximal portion (202) configured to contact the electrically conductive lead (12B) proximally of the openings (282), and
a distal portion (200) projecting beyond the proximal portion (202) distally thereof, the distal portion (200) provided with sculpturing (281) configured to engage the openings (282) to facilitate immobilizing the electrically conductive clip (18) in the bridge-like position between the semiconductor chip (14) and electrically conductive lead (12B).

## Description

### Technical field

The description relates to manufacturing semiconductor integrated circuit devices.

Solutions as described herein can be applied to power semiconductor devices such as power QFN packages, for automotive products, for instance.

### Background

In power semiconductor integrated circuit devices, the current transferred from the high-power section to the output pads of the device can be significant. Clips are used for that purpose in the place of wires.

Clips are currently stamped from flat material. Pins are also created extruding the material by punching with the purpose of centering the clip on the leadframe. Recesses are created at corresponding leadframe positions to house the clip pins for centering purposes.

In small packages (power Quad-Flat No Leads - QFNs - for instance) and/or if several channels are desired in the final package, more pads are needed and the dimensions for recesses on leadframe and clips may become relatively small.

The relatively small dimensions may lead to difficulties in clips manufacturing and handling.

Moreover, providing several recesses on the pads may cause the pads to be undesirably uneven, not flat.

### Object and summary

Solutions as described herein aim at addressing the issues discussed in the foregoing.

Such an object can be achieved via a method having the features set forth in the claims that follow.

One or more embodiments relate to a corresponding integrated circuit semiconductor device.

The claims are an integral part of the technical teaching provided in respect of the embodiments.

In solutions as described herein a clip with determined shape is formed starting from metallic material (e.g., copper).

In solutions as described herein such a clip may be provided with pins formed via additive manufacturing technique, optionally Laser Induced Forward Transfer (LIFT).

Solutions as described herein take advantage of peripheral features of the leadframe for centering purposes, without additional recesses on the pads.

Solutions as described herein may also apply to leadframes of the pre-molded type.

Solutions as described herein contemplate providing a leadframe, mounting a die thereon, forming electrical connections between the die and leads in the leadframe through clip bonding.

### Brief description of the several views of the drawings

One or more embodiments will now be described, by way of example only, with reference to the annexed figures, wherein:
Figures 1 and 2 are plan views illustrative of the structure of a power semiconductor device,
Figure 3 is illustrative of clip manufacturing method,
Figure 4 is a cross-sectional view along line IV-IV of Figure 2,
Figure 5 is a plan view illustrative of the structure of a power semiconductor device,
Figures 6 and 7 are a plan view and a cross-sectional view respectively, illustrative of a clip embodiment of the present description,
Figure 8 is a plan view illustrative of a clip as described herein, mounted on a semiconductor device,
Figures 9 and 10 are a plan view and cross-sectional view respectively, of a portion of Figure 8 indicated by the arrow IX,
Figures 11 and 12 are illustrative of the same portion of Figure 8 after a further processing step.

Corresponding numerals and symbols in the different figures generally refer to corresponding parts unless otherwise indicated. The figures are drawn to clearly illustrate the relevant aspects of the embodiments and are not necessarily drawn to scale. The edges of features drawn in the figures do not necessarily indicate the termination of the extent of the feature.

### Detailed description

In the ensuing description one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

Moreover, particular conformations, structures, or characteristics may be combined in any adequate way in one or more embodiments.

The headings/references used herein are provided merely for convenience and hence do not define the extent of protection or the scope of the embodiments.

For simplicity and ease of explanation, throughout this description, and unless the context indicates otherwise, like parts or elements are indicated in the various figures with like reference signs, and a corresponding description will not be repeated for each and every figure.

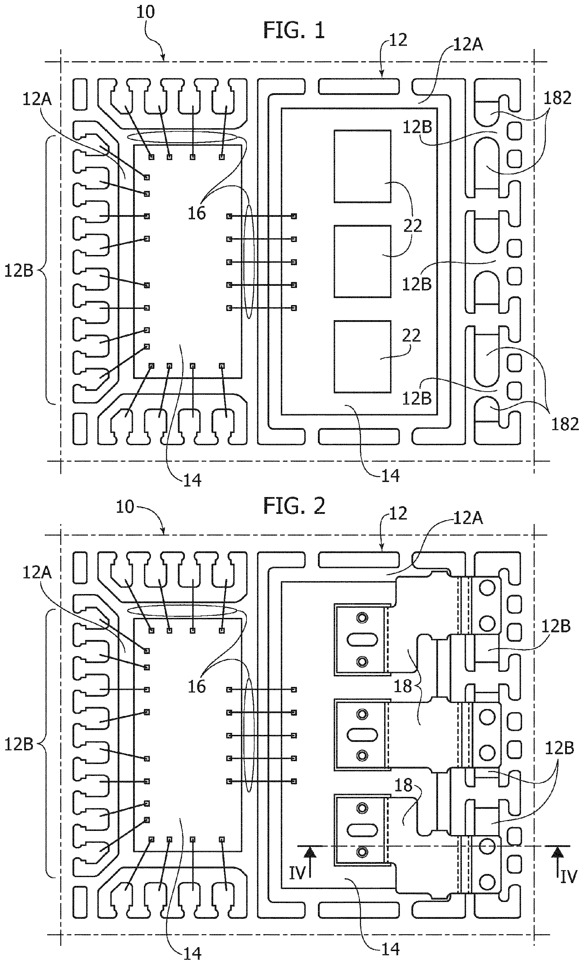

Figures 1 and 2 illustrate the structure of a power semiconductor device 10 comprising a low-power section (illustrated on the left-hand side of both Figures 1 and 2) e.g., a controller die or chip, attached on a first die pad 12A in a leadframe 12 and a high-power section (illustrated on the right-hand side of Figures 1 and 2) e.g., one or more power dice of chips attached on one or more die pads 12A in the leadframe 12.

As used herein, the terms chip/s and die/dice are regarded as synonymous.

An array of leads 12B is arranged around the die pads 12A having the low-power and the high-power dice mounted thereon.

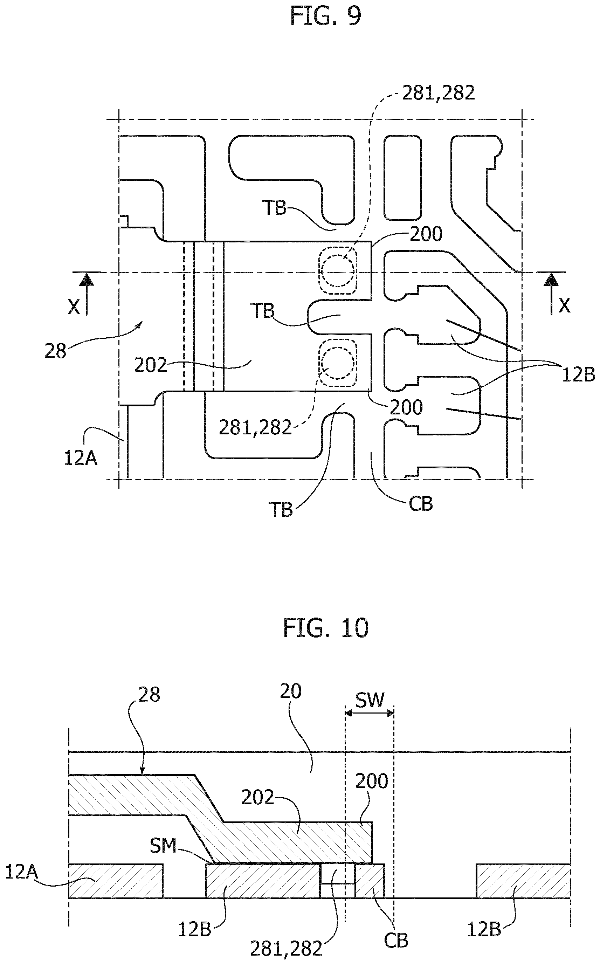

As illustrated herein by way of example, an integrated circuit semiconductor device such as the device 10 comprises, in addition to a substrate (leadframe) 12 having one or more semiconductor chips or dice 14 arranged thereon:
electrically conductive formations 16, 18 coupling the semiconductor chip(s) 14 to leads (outer pads) 12B in the substrate, and
an insulating encapsulation (e.g., a resin, visible only in Figure 10 and designated there with reference 20) molded on the assembly thus formed to complete the plastic body of the device 10.

The designation "leadframe" (or "lead frame") is currently used (see, for instance the USPC Consolidated Glossary of the United States Patent and Trademark Office) to indicate a metal frame that provides support for an integrated circuit chip or die as well as electrical leads to interconnect the integrated circuit in the die or chip to other electrical components or contacts.

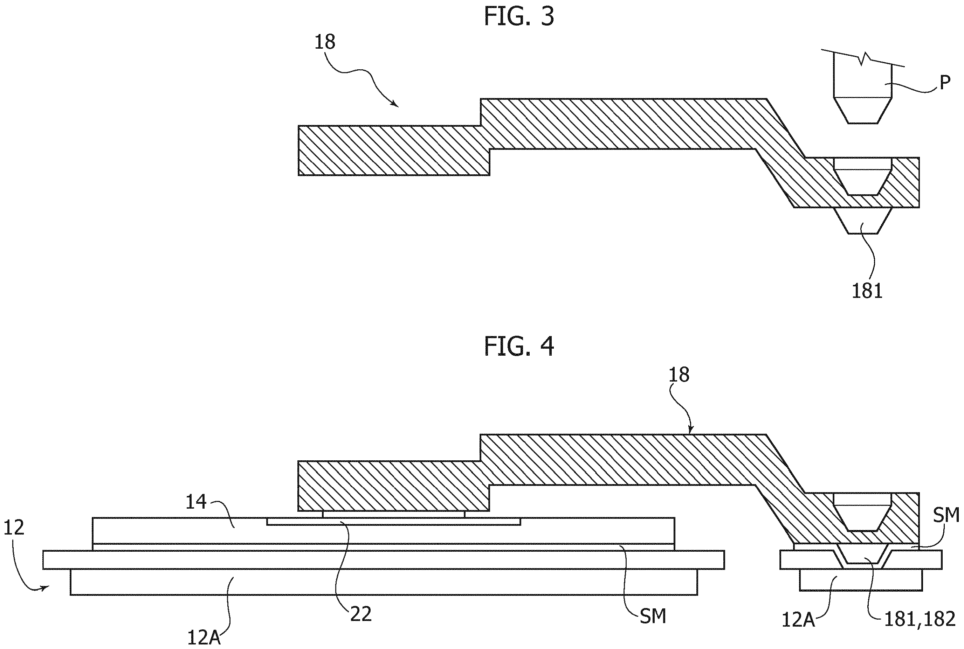

Essentially, a leadframe 12 comprises an array of electrically-conductive formations (or leads, e.g., 12B) that from an outline location extend inwardly in the direction of a semiconductor chip or die (e.g., 14) thus forming an array of electrically-conductive formations from a die pad (e.g., 12A in Figure 4) configured to have at least one (integrated circuit) semiconductor chip or die attached thereon. This may be via conventional means such as a die attach adhesive (a die attach film or DAF, for instance).

In certain cases, a leadframe can be of the pre-molded type, that is a type of leadframe comprising a sculptured metal (e.g., copper) structure formed by etching a metal sheet and comprising empty spaces that are filled by an insulating compound (a resin, for instance) "pre-molded" on the sculptured metal structure.

In current manufacturing processes of (integrated circuit) semiconductor devices plural devices/leadframes are processed concurrently.

Several leadframes are arranged in a leadframe strip and held together via connecting bars running around every individual leadframes. Leadframes are connected to the connecting bars via so-called tie bars, that is bridge-like formations which connect the pads (e.g., 12A) or the leads (e.g., 12B) of a leadframe to the connecting bars.

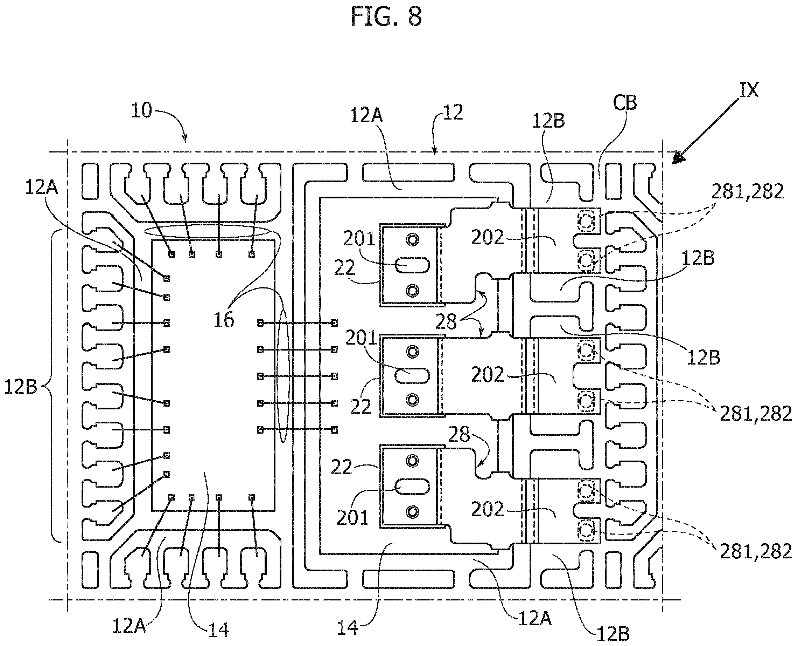

Connecting bars and tie bars are visible in Figures 8 to 10, and are indicated therein respectively with the references CB and TB.

The connecting bars are removed (e.g., by sawing) in a final "singulation" step to obtain individual devices.

As noted, electrically conductive formations 16, 18 are provided coupling the semiconductor chip(s) 14 to leads (outer pads) 12B in the substrate.

In power semiconductor devices (e.g., the device 10 illustrated in Figures 1 and 2) the current transferred from the high-power section to the output pads 12B of the device can be significant. As shown on the right-hand side of Figure 2, clips 18 are thus used for that purpose in the place of wires.

Wires 16 can still be used, as shown on the left-hand side of Figure 2, to provide electrical coupling to a low-power section (e.g., a controller) in the device.

That is, as illustrated in Figures 1 and 2, electrically conductive formations are provided comprising wire bonding patterns 16 coupling the low-power section (left-hand side of Figures 1 and 2, for instance) to selected ones of the leads 12B. These wire bonding patterns are coupled to die pads provided at the front or top surfaces of the chips (not visible in the figures).

Conversely, clips are used to couple the high-power section (right-hand side of Figure 2) to selected ones of the leads 12B acting as (power) output pads of the device 10. Using clips in the place of wires accounts for the fact that the current transferred from the high-power section to the output pads in a power semiconductor device may be significant.

According to a conventional approach, clips 18 as illustrated, for instance, in Figure 3, are formed by stamping flat metallic (e.g., copper) material. Pins 181 are also formed (by punching, P) in the terminal part of the clip (on the right-hand side of Figure 3) which will be coupled to the lead 12.

The pins 181 and corresponding recessed portions 182 (as illustrated in Figure 1) of the leads 12B in the leadframe 12 facilitate clip centering when mounting the clip on the leadframe-chip assembly.

The cross-sectional view of Figure 4 illustrates how a clip 18 as shown in Figure 3 can be included in the high-power section of a semiconductor device as illustrated in Figure 2 so that the clip 18 can provide electrical coupling between the (integrated circuit) chip or die 14 and one of the leads 12B.

The distal end (on the right side in Figure 4) of the clip 18 is positioned with the pin 181 inserted in the recessed portion 182 of the lead 12B. Solder material SM is used to form the electrical connection therebetween.

The proximal end (on the left side in Figure 4) of the clip 18 can be soldered (via solder material, SM) to the bonding pads 22 located on the front/top surface of the chip 14.

A device structure as discussed so far is conventional in the art, which makes it unnecessary to provide a more detailed description herein.

As noted, when manufacturing small sized power devices or when several electrical channels are involved, the method just described for providing electrical coupling to the power section of the device via clips may be faced with various difficulties.

For instance, when several channels are desired, it may become difficult to provide the (power) output leads 12B with recesses 182 while keeping the lead 12B flat.

Furthermore, as a consequence of the little room available, producing relatively small clips 18 with pins 181 by stamping may be difficult.

In case of small package devices, those problems may already appear when more than two channels (and thus more than two clips) are desired.

A way to address that problem may involve improving clip stamping technology and machining or choosing a different clip material.

These methods have the disadvantage of increasing production costs and, additionally, a different material for the clips may result in a degradation of the electrical performance of the device.

Another possible way to address the problem may involve increasing package size, thus imposing constraints on device design.

Solutions as described herein do not involve forming additional recesses on the pads of the leadframe.

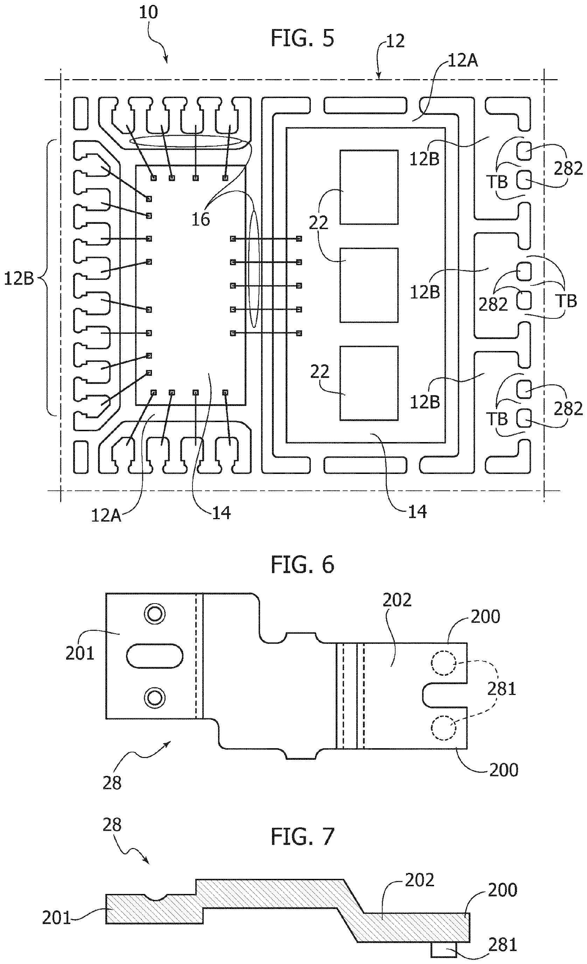

Figure 5 is illustrative of a leadframe 12 with chips 14 mounted thereon similar to the one illustrated in Figure 1, having no recesses 182.

Solutions as described therein can be applied to standard (not pre-molded) leadframes as well as to leadframes of the pre-molded type (with the addition of an additional processing step).

In the following the case of a standard leadframe 12, that is not of the pre-molded type, will be discussed for simplicity.

As discussed, manufacturing processes of semiconductor devices currently involve concurrent manufacturing of plural devices starting from plural leadframes (or leadframe portions) 12 held together in a leadframe strip via connecting bars indicated with CB in Figure 8. Each leadframe (portion) 12 is connected to the connecting bars CB via bridge-like "tie bars" TB.

That is, in solutions as discussed herein, plural leadframe (portion), may be included in a set (e.g., a strip) of electrically conductive substrates 12 having respective die mounting locations 12A. The electrically conductive substrates (leadframes) in such a set are coupled via sacrificial connecting bars CB between electrically conductive leads 12B in adjacent electrically conductive substrates 12 in the set.

As discussed in the following, these electrically conductive substrates 12 in the set or strip that are coupled via the sacrificial connecting bars CB (which extend transverse to the length of the leadframe set or strip) are processed concurrently.

Such processing involves:
arranging semiconductor dice 14 at the respective die mounting locations (die pads 12A), and
arranging electrically conductive clips in a bridge-like position between semiconductor dice 14 arranged at respective die mounting locations 12A and electrically conductive leads 12B in arrays of electrically conductive leads 12B of the leadframes 12 in the set or strip to provide electrical coupling therebetween.

Subsequent to such processing, the leadframe set or strip (having the semiconductor dice 14 and the clips attached thereon) is cut at the sacrificial connecting bars. In that way, "singulated" semiconductor devices are provided with electrically conductive leads 12B having notches at the periphery of each leadframe/device resulting from singulation.

As visible on the right in Figure 5, the connecting bars CB between the various leadframes (leadframe portions) in the set or strip have, on both sides of them, openings (e.g., aperture or holes) 282 located at the (mutually facing) peripheral regions of two leadframes 12 in the set or strip.

Once the leadframe set or strip (having the semiconductor dice 14 and the clips attached thereon) is cut at the sacrificial connecting bars CB, by removing the connecting bars, the openings (holes) 282 give rise to notches at the periphery of each "singulated" leadframe/device.

It may be appreciated that providing the openings 282, e.g., as through holes, during the manufacturing process of the leadframe 12 (e.g., via etching of a metal strip) does not involve any additional processing step.

The actual design of the leadframe 12 may differ from what is illustrated in Figure 5; however, openings such as 282 may be provided wherever suitable during the leadframe forming step (e.g., via photoetching).

Openings such as 282 may be advantageously used for clip centering purposes at the cost of a (simple) modification of the clip.

Figures 6 and 7 are illustrative of a clip 28 configured to take advantage of the openings 282 as centering features.

To better appreciate the shape and design of such a clip, both a plan view (Figure 6) and a side view (Figure 7) are presented herein.

Clips 28 as illustrated in the figures present, compared to clips 18 illustrated in Figure 3, a longer "tail" 200, namely a distal portion 200 projecting beyond the proximal portion 202, in order to reach the openings 282 at the periphery of the leadframe 12.

It is noted that any other detail of the particular shape of the clip 28 illustrated in Figures 6 and 7 is merely exemplary of a possible design of a clip 28; clips with different shapes, suited to match the particular design of a leadframe may be provided.

As illustrated, the distal portion (or "tail") 200 of the clip 28 may have a fork-like (rake-like) shape comprising plural prongs projecting beyond (and distally of) the planar proximal portion 202.

As discussed in the following, the plural prongs may be provided with sculpturing (e.g., pins) 281 configured to engage respective openings 282 at the periphery of the leadframe 12.

The end portion 200,202 may also be provided as a downset portion of the clip 28.

Clips 28 as described herein may be provided via otherwise conventional methods (stamping or coining, for instance) that are known to those of skill in the art.

Pins 281 on the back (bottom) surface of the tail portion 200 of the clip 28 are provided to be fitted in the openings or holes 282 (that is, to engage or mate with the holes 282), thus facilitating centering of the clip 28 during subsequent processing steps.

Pins 281 may be provided via any known techniques suited for that purpose (such as punching, as illustrated in Figure 3).

An additive manufacturing technique such as laser-induced forward transfer (LIFT) may be advantageously used.

The acronym LIFT denotes a deposition process where material from a donor tape or sheet is transferred to an acceptor substrate (here, the back/bottom surface of the clip 28) facilitated by laser pulses.

General information on the LIFT process can be found, for instance, in P. Serra, et al.: "Laser-Induced Forward Transfer: Fundamentals and Applications", in Advanced Materials Technologies/Volume 4, Issue 1.

Using an additive technique such as LIFT may be advantageous inasmuch such a technique may facilitate forming sculpturing 282 (such as pins, for example) in smaller clips, which may be critical to achieve via conventional techniques such as punching.

Figures 8 and 9, the latter being the portion of Figure 8 indicated by the arrow IX presented in an enlarged scale, illustrates clips 28 (three clips in this example) as just described mounted on a leadframe 12 (e.g., the leadframe of Figure 5) to provide electrical coupling between the power chip 14 (via the die pads 22 on the front/top surface of the chip 14) and the leads 12B of the leadframe 12.

It is noted that Figure 8 illustrates also a portion of the neighboring leadframe 12 separated by the connecting bar CB.

In fact, as mentioned before, in current manufacturing process plural leadframes 12 are processed concurrently. The plurality of leadframes is arranged in a strip of leadframes 12 wherein individual leadframes are separated by connecting formations (e.g., the connecting bars) CB.

Every individual leadframe is connected to the respective connecting bars by respective tie bars TB.

The portions 201 and 202 of the clip 28 contact respectively the die pad 22 and the lead 12B, thus providing the electrical coupling between chip 14 and lead 12B.

Similar to conventional clip mounting, solder material may be used to form the connection between the portion 202 of the clip 28 and the lead 12B and between the portion 201 and the die pad 22.

The tails 200 extend toward (and possibly partially overlap with) the connecting bar CB so that the pins 281 on the back/bottom surface of the tail may be housed in the holes 282 defined by the tie bars TB.

To summarize the discussion above is exemplary of one or more electrically conductive clips 28 arranged in a bridge-like position between a semiconductor die 14 and one or more electrically conductive leads 12B to provide electrical coupling therebetween.

As illustrated, the electrically conductive clip 28 has an end 200, 202 that is configured to be coupled to an electrically conductive lead 12B.

As illustrated, such a clip end comprises:
a planar proximal portion 202 configured to contact the electrically conductive lead 12B proximally of the openings 282, and
a distal portion 200 projecting beyond the proximal portion 202 distally of the proximal portion 202.

As illustrated, the distal portion is provided with sculpturing 281 (e.g., pins 282 as illustrated in Figure 7) configured to engage the openings 282 to facilitate immobilizing the electrically conductive clip 28 in the bridge-like position between the semiconductor chip 14 and the electrically conductive lead 12B.

This is in contrast with the arrangement disclosed in Italian patent application 102022000001649 not yet available to the public at the time of filing the present application, where a clip is shown having dedicated immobilization areas configured for welding or gluing provided at opposed lateral ends of the clip.

When processing leadframes of the pre-molded type the method described previously involve an additional step.

In that case, the openings 281 are filled during the pre-molding step with pre-molding compound and cannot serve, as they are, as centering features for the pins 282.

The pre-molding compound filling the openings 281 may be removed in an additional step, so that these spaces are clean of premold resin before mounting the clip 28 on the leadframe 12. For instance, this can be done by etching after leadframe premolding or by other methods like laser removal.

After mounting the clips 28 on the leadframe and chip assembly, an electrically insulating molding compound (e.g., an epoxy resin) is molded onto the assembly to provide the device 10 with a protective plastic package.

Figure 10 is a cross-sectional view along line X-X of Figure 9 illustrating the devices 10 after molding the molding compound 20 onto the devices.

The portion which is removed in the singulation step is indicated by two dashed lines SW. The singulation step may be performed, for example, by sawing or any other adequate technique which may be known per se to those skilled in the art.

In the singulation step the connecting bars CB are removed completely, thus dividing the device strip into individual devices 10.

It is noted that in the case of the tail 200 partially overlapping with the connecting bar CB, also a portion of the tail 200 of the clip 28 is removed during the singulation step. As illustrated in the following figures this causes the tail 200 to be visible on the side (on the right side in Figure 10) of the device.

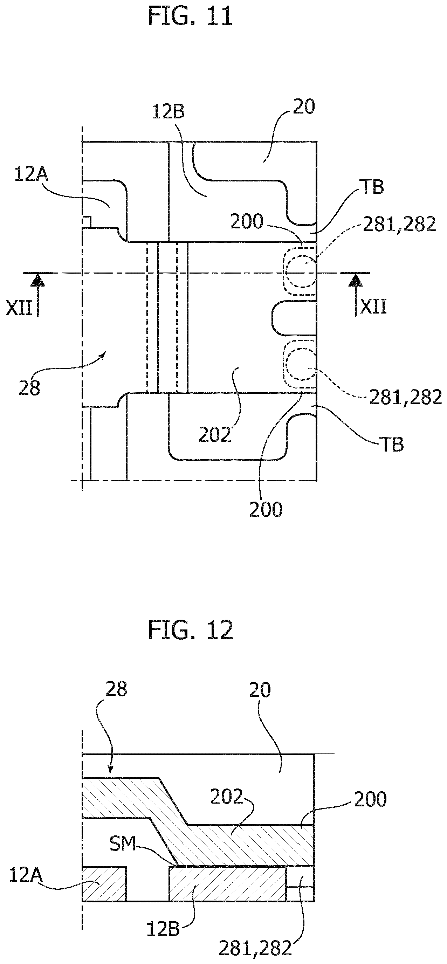

Figures 11 and 12 illustrate the same portion of the device as illustrated respectively in Figures 9 and 10 after singulation has been performed.

The steps discussed so far are merely exemplary as in actual processes other steps may be added or performed in a different manner.

Without prejudice to the underlying principles, the details and embodiments may vary, even significantly, with respect to what has been described by way of example only without departing from the extent of protection. The extent of protection is determined by the annexed claims.

## Claims

1. A method, comprising:
arranging at least one semiconductor die (14) at a die mounting location (12A) of an electrically conductive substrate (12), the electrically conductive substrate (12) comprising an array of electrically conductive leads (12B) having openings (282) at the periphery of said electrically conductive substrate (12),
arranging at least one electrically conductive clip (28) in a bridge-like position between the at least one semiconductor die (14) and at least one electrically conductive lead (12B) in the array of electrically conductive leads (12B) to provide electrical coupling therebetween, wherein the at least one electrically conductive clip (28) has an end (200, 202) configured to be coupled to the at least one electrically conductive lead (12B) in the array of electrically conductive leads (12B), said end (200, 202) comprising:
a planar proximal portion (202) configured to contact the at least one electrically conductive lead (12B) proximally of said openings (282), and
a distal portion (200) projecting beyond the proximal portion (202) distally thereof, the distal portion (200) provided with sculpturing (281) configured to engage said openings (282) to facilitate immobilizing the at least one electrically conductive clip (18) in said bridge-like position between the at least one semiconductor chip (14) and the at least one electrically conductive lead (12B) in the array of electrically conductive leads (12B).

2. The method of claim 1, wherein said distal portion (200) has a fork-like shape comprising plural prongs projecting beyond the proximal portion (202) distally thereof, the plural prongs provided with sculpturing (281) configured to engage respective openings (282) at the periphery of said electrically conductive substrate (12).

3. The method of claim 1 or claim 2, wherein said end (200, 202) is provided as a downset portion of the electrically conductive clip (28).

4. The method of any of claims 1 to 3, comprising providing said sculpturing (281) as at least one protrusion from the distal portion (200) of said end (200, 202) of the at least one electrically conductive clip (28).

5. The method of any of the previous claims, comprising providing said sculpturing (281) via additive manufacturing.

6. The method of any of the previous claims, comprising providing said sculpturing (281) via laser induced forward transfer, LIFT processing.

7. The method of any of the previous claim, wherein the electrically conductive substrate (12) is a pre-molded leadframe with pre-molding compound in said openings (282), wherein the method further comprises removing said pre-molding compound from said openings (282) prior to arranging the at least one electrically conductive clip (28) in a bridge-like position between the at least one semiconductor die (14) and at least one electrically conductive lead (12B) in the array of electrically conductive leads (12B).

8. The method of any of the previous claim, comprising soldering (SM) the at least one electrically conductive clip (28) to the at least one semiconductor chip (14) and to the at least one electrically conductive lead (12B) to provide electrical coupling therebetween, with the at least one electrically conductive clip (28) immobilized in said bridge-like position as a result of the sculpturing (281) in said distal portion (200) engaging said openings (282).

9. The method of any of the previous claims, comprising:
including the electrically conductive substrate (12) in a set of electrically conductive substrates (12) having respective die mounting locations (12A), wherein the electrically conductive substrates (12) in the set are coupled via sacrificial connecting bars (CB) between electrically conductive leads (12B) in adjacent electrically conductive substrates (12) in the set,
processing the electrically conductive substrates (12) in the set coupled via the sacrificial connecting bars (CB) by arranging semiconductor dice (14) at respective die mounting locations (12A) and arranging electrically conductive clips (28) in a bridge-like position between semiconductor dice (14) arranged at respective die mounting locations (12A) and electrically conductive leads (12B) in arrays of electrically conductive leads (12B) of the electrically conductive substrates (12) in the set to provide electrical coupling therebetween, and
subsequent to said processing, cutting (SW) at the sacrificial connecting bars (CB) the set of electrically conductive substrates (12) having said semiconductor dice (14) and said electrically conductive clips (28) arranged thereon to produce, as a result of said cutting (SW), singulated semiconductor devices wherein the distal portions (200) of the electrically conductive clips (28) are exposed at the periphery of the singulated semiconductor devices.

10. A device, comprising:
at least one semiconductor die (14) arranged at a die mounting location (12A) of an electrically conductive substrate (12), the electrically conductive substrate (12) comprising an array of electrically conductive leads (12B) with notches (282) at the periphery of said electrically conductive substrate (12),
at least one electrically conductive clip (28) arranged in a bridge-like position between the at least one semiconductor die (14) and at least one electrically conductive lead (12B) in the array of electrically conductive leads (12B) to provide electrical coupling therebetween, wherein the at least one electrically conductive clip (28) has an end (200, 202) coupled to the at least one electrically conductive lead (12B) in the array of electrically conductive leads (12B), said end (200, 202) comprising:
a planar proximal portion (202) contacting the at least one electrically conductive lead (12B) proximally of said notches (282), and
a distal portion (200) projecting beyond the proximal portion (202) distally thereof, the distal portion (200) provided with sculpturing (281) engaging said notches (282) and immobilizing the at least one electrically conductive clip (18) in said bridge-like position between the at least one semiconductor chip (14) and the at least one electrically conductive lead (12B) in the array of electrically conductive leads (12B), wherein the distal portion (200) of the at least one electrically conductive clip (28) is exposed at the periphery of the device.
